(19) Europäisches Patentamt
European Patent Office
Office européen des brevets

(11) Publication number: **0 286 097 B1**

(12) **EUROPEAN PATENT SPECIFICATION**

(45) Date of publication of patent specification: **02.03.94**

(51) Int. Cl.$^5$: **H01L 21/316**, C23C 16/46, C23C 16/40

(21) Application number: **88105561.0**

(22) Date of filing: **07.04.88**

(54) **Method of forming silicon dioxide glass films.**

(30) Priority: **10.04.87 US 36979**

(43) Date of publication of application:
**12.10.88 Bulletin 88/41**

(45) Publication of the grant of the patent:
**02.03.94 Bulletin 94/09**

(84) Designated Contracting States:
**BE DE FR GB IT NL**

(56) References cited:
**EP-A- 0 212 691**
**US-A- 3 834 939**
**US-A- 4 168 330**

**CHEMICAL ABSTRACTS, vol. 87, 1977, pages 19,20, abstract no. 168679y, Columbus, Ohio, US; V.A. SUTYAGIN et al.: "Thermal and radiation-induced degradation of polysiloxane layers produced by an electron-beam method" & Khim. Vys. Energ. 1977, vol. 11, no. 5, pages 308-312**

(73) Proprietor: **AIR PRODUCTS AND CHEMICALS, INC.**
**Route no. 222**
**Trexlertown Pennsylvania 18087(US)**

(72) Inventor: **Lagendijk, Andre**
**2081 Fire Mountain Drive**
**Oceanside, CA 92054(US)**

(74) Representative: **Schwabe - Sandmair - Marx**
**Stuntzstrasse 16**
**D-81677 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

### Field of the Invention

This invention relates to the manufacture of semiconductor devices and, specifically, to the deposition of $SiO_2$ coatings on semiconductor devices.

### Background of the Invention

It is common practice in the industry to form silicon dioxide films, either doped or undoped according to the particular application, on or as a layer in semiconductor devices. The literature is replete with discussions of the function of such layers and various methods of forming silicon dioxide layers. See, for example, Thomas, HANDBOOK OF TRANSISTORS, SEMICONDUCTORS, INSTRUMENTS AND MICROELECTRONICS, Prentice Hall, Englewood Cliffs, N.J. 1968 and the extensive publications of the J. C. Schumacher Company, e.g. Tetraethyl Orthosilicate (TEOS), Product Data Sheet No. 6; Tetraethyl Orthosilicate for Semiconductor High Temperature Silicon Dioxide Depositions, Product Application Note No. 8; TEOS and Liquid Dopant Sources for CVD $SiO_2$, PSG, and BPSG, Product Application Note No. 15; Adams and Capio, The Deposition of Silicon Dioxide Films at Reduced Pressure, Technical Article Reprint No. 5.

Thus, the deposition of doped and undoped silicon oxide films is an important process in semiconductor device fabrication. The decomposition process commonly utilizes toxic and pyrophoric gases. The use of safer liquid sources is the goal of many investigators. F. S. Becker and D. Pawlik, ECS 85-2 (85)380, ECS 86-8 p148 "A New LPCVD Borophosphosilicate Glass Process Based on the Doped Deposition of TEOS-Oxide". G. Smolinsky and T.P.H.F. Wendling, JECS 132(85)950 "Measurement of the Temperature Dependent stress of Silicon Oxide Films Prepared by a Variety of CVD Methods". G. Smolinsky and R. E. Dean "LPCVD of Silicon Oxide Films in the Temperature Range of 410 to 600 °C from Diacetoxyditertiarybutoxysilane". F. S. Becker, D. Pawlik, H. Schaefer, and G. Staudigl, JVST B4 (86)232 "Process and Film Characterization of Low Pressure TEOS-Borophosphosilicate Glass". D. S. Williams and E. A. Dein "LPCVD of Borophosphosilicate Glass from Organic Reactants". The thermal decomposition of tetraethoxysilane (TEOS) has been used for over twenty years to obtain undoped silicon dioxide films in the temperature range from 600 to 800 °C, A. Hochberg and D. O'Meara "LPCVD of Silicon Dioxide Films from Tetraethoxysilane".

The development of a phosphorus doped film, using liquid sources, has been hindered by the lack of a suitable phosphorus source. Trimethylphosphate (TMPO) with TEOS does not provide more than 3 w/o phosphorus, while trimethylphosphite (TMPI) is too reactive above 600 °C. TMPO has been used with TEOS at lower temperatures to produce doped films. The utilization of this process in semiconductor fabrication is limited due to the temperature dependence of phosphorus incorporation and the film growth rate dependence on phosphorus to silicon source ratios. To obtain a 4 w/o phosphorus film, the temperature must be increased to 680 °C, where the high reactivity of TMP produces very non-uniform depositions.

A liquid source producing undoped silicon oxide films at depositions temperatures from 500 to 600 °C would allow for controlled incorporation of phosphorus from TMPi as well as boron doping from trimethylborate (TMB).

The chemistry of the siloxanes is well developed, see. e.g. article entitled "Silicones" in Kirk-Othmer, ENCYCLOPEDIA OF CHEMICAL TECHNOLOGY. While there are some variations in the terminology used to describe the siloxanes, the present description of compounds of the formula

$$(H_nR_{2-n}Sio)_m$$

wherein $n = 0\text{-}2$, and m is 3 or greater, and R is lower 1-8 carbon alkyl, aryl or aralkyl, is consistent with commonly used rules of nomenclature. Siloxanes and polymers thereof, frequently called silicones, have found application in a great variety of industries and for a wide array of purposes in industry, medicine, the arts and in the household.

Siloxanes are used in the semiconductor and electronics industry, principally as silicone potting, shock absorbing, or coating materials, and in masks used in manufacturing of semiconductors. A process for forming a doped oxide film and a composite article by modifying polysiloxane with a dopant, coating the mixture on a substrate and heating coated substrate to diffuse the dopant onto the substrate is described in U.S. Patent Nos. 4605450, 4571366 and 4619719, wherein a silicon tetra-alkoxide is reacted with a limited amount of water to produce a low molecular weight, soluble polyorganosiloxane. The polyorganosiloxane is

subsequently admixed with a reactive dopant source to form a soluble metallosiloxane polymer. The metallosiloxane polymer is coated onto a semiconductor wafer substrate material to produce a metallosiloxane-wafer composite article. The composite article is heated to produce an impurity doped semiconductor wafer suitable for electronic applications. U.S. Patent No. 4,168,330 to Kaganowicz discloses the use of some siloxanes in the deposition of silicon oxides by glow discharge at low temperatures. Insofar as is known, however, siloxanes have not been thermally decomposed at high temperatures to form $SiO_2$ coatings or layers in the manufacture of semiconductors.

## Summary of the Invention

It has now been discovered that siloxanes of the formula

$$(H_nR_{2-n}SiO)_m$$

wherein n = 0-2, and m is 3 or greater, R being lower 1-8 carbon alkyl, aryl, or aralkyl, can be decomposed by oxidation at from about 400° C. and generally from about 500° C. to about 750° C. in a reduced pressure reactor to form a highly satisfactory $SiO_2$ layer or coating or, by adding dopants, to form a highly satisfactory doped $SiO_2$ layer in the manufacture of semiconductor devices.

While the principles involved herein are widely applicable to siloxanes in general, cyclic and linear, the greatest advantage is accomplished using cyclic siloxanes, one example of which, 1,3,5,7 tetramethylcyclotetrasiloxane (TMCTS), is commercially available and seems, presently, to provide an approximately optimum set of economic and technical advantages. Octamethyltetracyclosiloxane (OCMET) is also advantageously used, and other siloxanes may be considered as potentially equivalents.

## Description of the Preferred Embodiment

The process of this invention is carried out by heating the semiconductor device to which the $SiO_2$ or doped $SiO_2$ coating or layer is to be added to a suitable temperature between about 400° C. and about 750° C., generally in the range of 550° - 750° C., sufficient to decompose a mixture of the siloxane and oxygen. The heating is carried out in vacuo or at a reduced pressure, i.e. partial vacuum, generally In the pressure range of 0.133 mbar - 0.665 mbar (100 - 500 milliTorr (mTorr) for a period sufficient to form the desired thickness of film, which time is readily calculated from the rate of deposition, which is empirically determined for each siloxane and is a function of temperature and flow rate. The rate parameters are easily ascertained for a given system and are somewhat a function of the system, thus no one set of rate data is significant, and certainly not critical to the invention. The following examples illustrate the invention.

## Example 1

Commercially available tetramethylcyclotetrasiloxane (TMCTS) was purified and vacuum packaged in a quartz container. The container was incorporated in a standard low pressure chemical vapor deposition system capable of handling 10cm (4") diameter silicon wafers. TMCTS vapors were drawn from the quartz container, held at a constant temperature of about 16°C. The TMCTS vapors were mixed with oxygen prior to entry into the furnace containing the silicon wafers. Deposition runs were made according to established prior art procedures with certain variables controlled to determine whether suitable $SiO_2$ films could be deposited and, thereafter, to determine the effect of various process parameters on the deposition of $SiO_2$ films on the silicon wafers. The major process variables identified were $O_2$:TMCTS ratio and the deposition temperature. $SiO_2$ deposition rates were measured by standard film thickness measurements, using optical reflectance and ellipsometry. Maximum deposition rates were found to be at an $O_2$:TMCTS molar ratio of about 2:1. The deposition rates at this ratio as a function of temperature are shown in Table I.

Table I

$SiO_2$ Deposition at $O_2$:TMCTS Molar Ratio of 2:1

| Temperature | Deposition Rate |
|---|---|
| 550°C. | 2.5nm (25 Angstroms)/Min |
| 600°C. | 5.5nm (55 Angstroms)/Min |
| 700°C. | 35.5nm (355 Angstroms)/Min |

The activation energy for deposition appears to be 121kJ/mol (29 kcal/mol).

Example 2

Commercially available octamethylcyclotetrasiloxane (OCMET) was run using the protocol of Example 1. The deposition rate was very much lower than that observed with TMCTS, being only 0.5μm (5 Angstroms)/minute at 750°C.

As demonstrated, TMCTS may be used as a silicon oxide source in the temperature range of from about 400°C. to above 700°C., the optimum temperature being in the 550 to 700°C range.

The surprisingly high quality and deposition rates of $SiO_2$ using TMCTS makes it, presently, a greatly preferred siloxane; however, as demonstrated using OCMET, other siloxanes can be considered as potentially equivalent in the sense that deposition of $SiO_2$ can be accomplished. The siloxanes considered suitable for use in the present process are of the general formula

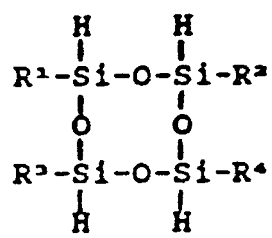

wherein $R^1$, $R^2$, $R^3$ and $R^4$ are hydrogen or lower alkyl, aryl or aralkyl having up to 8 carbons. In the preferred compound, all of $R^1$, $R^2$, $R^3$ and $R^4$ are methyl.

In a more general sense, the preferred class of siloxane compounds have the general formula

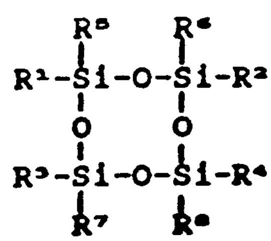

wherein, $R^5$, $R^6$, $R^7$, and $R^8$, as well as $R^1$, $R^2$, $R^3$ end $R^4$ are hydrogen or lower alkyl, aryl or aralkyl having up to 8 carbons.

In a still more general sense, analogous trimer, pentamer and hexamer siloxanes and other cyclic siloxanes are considered as suitable equivalents to the preferred compound and class of compounds. Indeed, in a still more general sense, cyclic and acyclic siloxane compounds of the formula

$(-H_nR_{2-n}SiO-)_m$

wherein $n = 0\text{-}2$, and m is 3 or greater and R is lower 1-8 carbon alkyl, aryl, or aralkyl are considered to be generally equivalent to the preferred compounds. Exemplary of such compounds are, of course, 1,3,5,7 tetramethylcyclotetrasiloxane and octamethyltetracyclosiloxane, as well as such other siloxanes as octamethyltrisiloxane, decamethyltetrasiloxane, octaphenylcyclotetrasiloxane, 1,3,5,7-tetramethyl-1,3,5,7-tetraphenylcyclotetrasiloxane, 1,1,1,3,5,5,5-heptamethyl-3-t-butylsiloxytrisiloxane, 1,1,1,3,5,5,5-heptamethyltrisiloxane and 1,1,3,5,5-pentamethyl-1,3,5-triphenyltrisiloxane.

Dopants may optionally be included in the mixture of oxygen, either pure or as air, to provide a suitably doped $SiO_2$ layer. For example, such dopants as phosphorus oxychloride, boron tribromide, phosphorous tribromide, antimony trioxide, phosphorus trichloride, and, in general, compounds of boron, germanium, phosphorus, arsenic, chromium, antimony and other dopant elements which are capable of being volatilized may be used.

Industrial Application

This invention finds application in the manufacture of semiconductor devices.

**Claims**

1. A process of manufacturing semiconductor devices, wherein a layer of silicon dioxide is formed on a heated substrate by heating said substrate to a temperature of about 400 °C to about 750 °C under reduced pressure of 0.133 mbar to 0.665 mbar (100 to 500 mTorr), flowing a mixture of a siloxane and an oxidant over the heated substrate and thermally decomposing said siloxane on the surface of the substrate to form said layer of silicon dioxide.

2. The process according to claim 1, wherein a layer of doped silicon dioxide is formed by further adding a dopant to the gaseous mixture flowed over said heated substrate.

3. The process according to claims 1 or 2, wherein said dopant is selected from the group consisting of compounds of boron, germanium, phosphorus, arsenic, chromium or antimony.

4. The process of claim 3, wherein the dopant is selected from phosphorus oxychloride, boron tribromide, phosphorus tribromide, phosphorus trichloride, and antimony trioxide.

5. The process of any of the claims 1 to 4, wherein said siloxane is a cyclic siloxane.

6. The process according to any of the claims 1 to 4, wherein the siloxane is selected from siloxanes having the general formula

   $(\text{-}H_nR_{2-n}SiO\text{-})_m$

   wherein n is 0 to 2, and m is 3 or greater and R is lower alkyl, aryl or aralkyl having up to 8 carbon atoms.

7. The process according to any of the claims 1 to 6, wherein the cyclic siloxane is selected from siloxanes having the general formula

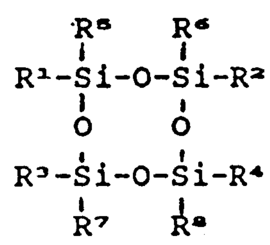

   wherein $R^1$, $R^2$, $R^3$, $R^4$, $R^5$, $R^6$, $R^7$ and $R^8$ are hydrogen or lower alkyl, aryl or aralkyl having up to 8

carbon atoms.

**8.** The process according to any of the claims 1 to 7, wherein the cyclic siloxanes are of the general formula of claim 7, wherein $R^1$, $R^2$, $R^3$ and $R^4$ are methyl.

**9.** The process according to claim 8, wherein the cyclic siloxanes are of the general formula of claim 7, wherein $R^1$, $R^2$, $R^3$ and $R^4$ are methyl, and $R^5$, $R^6$, $R^7$ and $R^8$ are hydrogen.

**10.** The process according to any of the claims 1 to 9, wherein the siloxane is selected from the group consisting of 1,3,5,7-tetramethylcyclotetrasiloxane (TMCTS), octamethylcyclotetrasiloxane (OCMET), octamethyltrisiloxane, decamethyltetrasiloxane, octaphenylcyclotetrasiloxane, 1,3,5,7-tetramethyl-1,3,5,7-tetraphenylcyclotetrasiloxane, 1,1,1,3,5,5,5-heptamethyl-3-tributylsiloxytrisiloxane, 1,1,1,3,5,5,5-heptamethyltrisiloxane and 1,1,3,5,5,-pentamethyl-1,3,5-triphenyltrisiloxane.

**11.** The process according to any of the claims 1 to 10, wherein the siloxane is TMCTS and the deposition temperature is in the range of 550 to 700 °C.

**Patentansprüche**

**1.** Verfahren zur Herstellung von Halbleitervorrichtungen, bei dem man eine Siliciumdioxidschicht auf einem erhitzten Substrat bildet, indem man das Substrat bei verringertem Druck von 0,133 mbar bis 0,665 mbar (100 bis 500 mTorr) auf eine Temperatur von etwa 400 °C bis etwa 750 °C erhitzt, über das erhitzte Substrat eine Mischung aus einem Siloxan und einem Oxidationsmittel fließen läßt und das Siloxan auf der Oberfläche des Substrats thermisch zersetzt, um die Siliciumdioxidschicht zu bilden.

**2.** Verfahren nach Anspruch 1, bei dem durch zusätzliche Zugabe eines Dotierungsmittels zu der gasförmigen Mischung, die man über das erhitzte Substrat leitet, eine Schicht von dotiertem Siliciumdioxid gebildet wird.

**3.** Verfahren nach Anspruch 1 oder 2, bei dem das Dotierungsmittel aus der aus Bor-, Germanium-, Phosphor-, Arsen-, Chrom- oder Antimonverbindungen bestehenden Gruppe ausgewählt ist.

**4.** Verfahren nach Anspruch 3, bei dem das Dotierungsmittel aus Phosphoroxychlorid, Bortribromid, Phosphortribromid, Phosphortrichlorid und Antimontrioxid ausgewählt ist.

**5.** Verfahren nach einem der Ansprüche 1 bis 4, bei dem das Siloxan ein cyclisches Siloxan ist.

**6.** Verfahren nach einem der Ansprüche 1 bis 4, bei dem das Siloxan aus Siloxanen mit der allgemeinen Formel

$$(-H_nR_{2-n}SiO-)_m$$

ausgewählt ist, in der n 0 bis 2, m 3 oder größer und R Niedrigalkyl, -aryl oder aralkyl mit bis zu 8 Kohlenstoffatomen ist.

**7.** Verfahren nach einem der Ansprüche 1 bis 6, bei dem das cyclische Siloxan aus Siloxanen mit der allgemeinen Formel

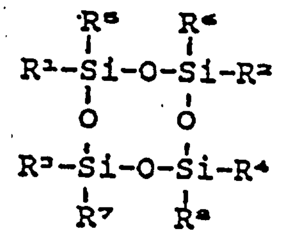

ausgewählt ist, in der $R^1$, $R^2$, $R^3$, $R^4$, $R^5$, $R^6$, $R^7$ und $R^8$ Wasserstoff oder Niedrigalkyl, -aryl oder

-aralkyl mit bis zu 8 Kohlenstoffatomen sind.

**8.** Verfahren nach einem der Ansprüche 1 bis 7, bei dem die cyclischen Siloxane die allgemeine Formel von Anspruch 7 haben, in der $R^1$, $R^2$, $R^3$ und $R^4$ Methyl sind.

**9.** Verfahren nach Anspruch 8, bei dem die cyclischen Siloxane die allgemeine Formel von Anspruch 7 haben, in der $R^1$, $R^2$, $R^3$ und $R^4$ Methyl und $R^5$, $R^6$, $R^7$ und $R^8$ Wasserstoff sind.

**10.** Verfahren nach einem der Ansprüche 1 bis 9, bei dem das Siloxan aus der aus 1,3,5,7-Tetramethylcyclotetrasiloxan (TMCTS), Octamethylcyclotetrasiloxan (OCMET), Octamethyltrisiloxan, Decamethyltetrasiloxan, Octaphenylcyclotetrasiloxan, 1,3,5,7-Tetramethyl-1,3,5-7-tetraphenylcyclotetrasiloxan, 1,1,1,3,5,5,5-Heptamethyl-3-tributylsiloxytrisiloxan, 1,1,1,3,5,5,5-Heptamethyltrisiloxan und 1,1,3,5,5-Pentamethyl-1,3,5-triphenyltrisiloxan bestehenden Gruppe ausgewählt ist.

**11.** Verfahren nach einem der Ansprüche 1 bis 10, bei dem das Siloxan TMCTS ist und die Abscheidetemperatur im Bereich von 550 bis 700 °C liegt.

## Revendications

**1.** Procédé de fabrication de dispositifs à semiconducteurs, dans lequel une couche de dioxyde de silicium est formée sur un substrat chauffé en chauffant ledit substrat à une température de l'ordre d'environ 400 °C à environ 750 °C à pression réduite de 0,133 à 0,665 mbar (100 à 500 mTorr), en faisant s'écouler un mélange de siloxane et un oxydant sur le substrat chauffé et en décomposant thermiquement ledit siloxane sur la surface du substrat pour former ladite couche de dioxyde de silicium.

**2.** Procédé selon la revendication 1, dans lequel une couche de dioxyde de silicium dopée est formée en ajoutant un dopant au mélange gazeux répandu sur ledit substrat chauffé.

**3.** Procédé selon les revendications 1 ou 2, dans lequel ledit dopant est choisi parmi le groupe formé de composés de bore, de germanium, de phosphore, d'arsenic, de chrome ou d'antimoine.

**4.** Procédé selon la revendication 3 dans lequel le dopant est choisi parmi l'oxychlorure de phosphore, le tribromure de bore, le tribromure de phosphore, le trichlorure de phosphore et le trixoyde d'antimoine.

**5.** Procédé selon l'une des revendications 1 à 4, dans lequel ledit siloxane est un siloxane cyclique.

**6.** Procédé selon l'une des revendications 1 à 4, dans lequel le siloxane est choisi parmi les siloxanes répondant à la formule générale

$(-H_nR_{2-n}SiO)_m$

dans laquelle n est 0 à 2, m est égal ou supérieur à 3 et R est un radical alkyle inférieur, aryle ou aralkyle ayant jusgu'à 8 atomes de carbone.

**7.** Procédé selon une des revendications 1 à 6, dans lequel le siloxane cyclique est choisi parmi les siloxanes répondant à la formule générale

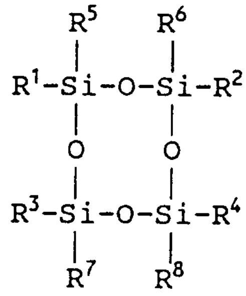

dans laquelle $R^1$, $R^2$, $R^3$, $R^4$, $R^5$, $R^6$, $R^7$ et $R^8$ sont l'hydrogène ou un radical alkyle inférieur, aryle ou aralkyle ayant jusqu'à 8 atomes de carbone.

**8.** Procédé selon l'une des revendications 1 à 7 dans lequel les siloxanes cycliques répondent à la formule générale de la revendication 7, $R^1$, $R^2$, $R^3$ et $R^4$ étant un radical méthyle.

**9.** Procédé selon la revendication 8, dans lequel les siloxanes cycliques répondent à la formule générale de la revendication 7, dans laquelle $R^1$, $R^2$, $R^3$ et $R^4$ sont un radical méthyle et $R^5$, $R^6$, $R^7$ et $R^8$ sont l'hydrogène.

**10.** Procédé selon l'une des revendications 1 à 9, dans lequel le siloxane est choisi parmi le groupe composé du 1,3,5,7-tétraméthylcyclotétrasiloxane (TMCTS), de l'octaméthylcyclotétrasiloxane (OCMET), de l'octaméthyltrisiloxane, le décaméthyltétrasiloxane, l'octaphénylcyclotétrasiloxane, lel,3,5,7-tétraméthyl-1,3,5,7-tétraphénylcyclotétrasiloxane, le 1,1,1,3,5,5,5-heptaméthyl-3-tributylsiloxytrisiloxane, le 1,1,1,3,5,5,5-heptaméthyltrisiloxane et le 1,1,3,5,5-pentaméthyl-1,3,5-triphényltrisiloxane.

**11.** Procédé selon l'une des revendications 1 à 10, dans lequel le siloxane est le TMCTS et la température de dépôt est de l'ordre de 550 à 700 °C.